Europäisches Patentamt

European Patent Office

Office européen des brevets

(19)

(11) Numéro de publication: **0 209 629 B1**

# FASCICULE DE BREVET EUROPEEN

(45) Date de publication du fascicule du brevet:
**12.09.90**

(21) Numéro de dépôt: **85401529.4**

(22) Date de dépôt: **24.07.85**

(51) Int. Cl.⁵: **C30B 13/02, C30B 29/48**

(54) **Procédé de préparation d'une zone de solvant pour la réalisation de composés semi-conducteurs.**

(43) Date de publication de la demande:
**28.01.87 Bulletin 87/5**

(45) Mention de la délivrance du brevet:
**12.09.90 Bulletin 90/37**

(84) Etats contractants désignés:
**DE GB**

(56) Documents cités:
**EP-A- 0 060 744**
**FR-A- 2 536 767**
**FR-A- 2 560 227**

(73) Titulaire: **COMMISSARIAT A L'ENERGIE ATOMIQUE, 31/33, rue de la Fédération, F-75015 Paris(FR)**

(72) Inventeur: **Fillot, Alain, Chemin des Ratz Les Eymes, F-38330 Saint Ismier(FR)**
Inventeur: **Gallet, Jean, Le Babolui Miribel Les Echelles, F-38380 Saint Laurant Du Var(FR)**
Inventeur: **Paltrier, Sylvain, 49Bis, rue des Ayguinards, F-38240 Meylan(FR)**
Inventeur: **Schaub, Bernard, 30, rue Gay Lussac, F-38100 Grenoble(FR)**

(74) Mandataire: **Mongrédien, André et al, c/o BREVATOME 25, rue de Ponthieu, F-75008 Paris(FR)**

## Description

La présente invention a pour objet un procédé de préparation d'une zone de solvant destinée à la fabrication de composés semiconducteurs ternaires ou quaternaires par la méthode dite de "transfert d'une zone de solvant".

Ce procédé est parfaitement bien adapté à la fabrication de composés ternaires de formule $Cd_xHg_{0,5-x}Te_{0,5}$ et de composés quaternaires de formule $Cd_xHg_{0,5-x}Te_ySe_{0,5-y}$, formules dans lesquelles $0 < x < 0,5$ et $0 < y < 0,5$. Ces composés présentent une largeur de bande interdite variant de façon continue avec les fractions atomiques $x$ et $y$, ce qui autorise ainsi la fabrication de photodétecteurs infrarouges fonctionnant à toute longueur d'onde supérieure à 0,8 μm.

D'un point de vue général, la méthode de transfert d'une zone de solvant permet d'élaborer des composés semiconducteurs monocristallins à une température inférieure à leur température de fusion, ce qui permet d'obtenir des composés très purs et de meilleure qualité cristalline que celle obtenue par les autres procédés de fabrication de monocristaux. Dans le cas particulier des composés semiconducteurs de formule $Cd_xHg_{0,5-x}Te_{0,5}$ ou de formule $Cd_xHg_{0,5-x}Te_ySe_{0,5-y}$, cette méthode permet de s'affranchir des difficultés liées à la présence de vapeur du mercure présentant une pression élevée à la température de fusion desdits composés.

Le principe général de la méthode dite de "transfert d'une zone de solvant" appliquée aux composés semiconducteurs de type II-VI a été clairement décrit dans un article de G.A. WOLFF et al. paru dans Transactions of the Metallurgical Society of Aime, vol. 242, mars 1968, pages 436-441.

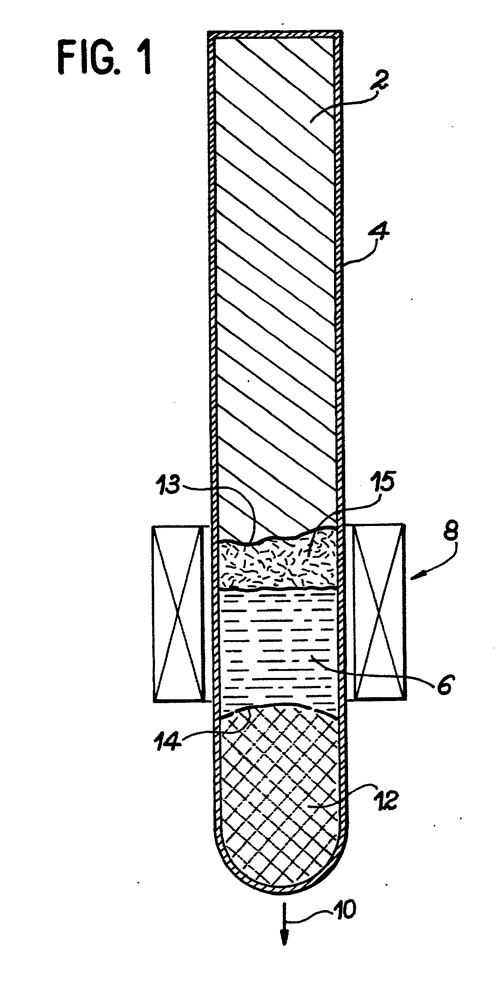

Cette méthode consiste, en se référant à la figure 1, à introduire un lingot 2 d'un composé semiconducteur polycristallin, appelé lingot "source", dans une nacelle cylindrique 4 en silice, en position verticale, pour y être traversé par une zone de solvant fondue 6, disposée au préalable à l'extrémité de la nacelle. Un four 8 permet de chauffer la nacelle et son contenu dans la partie en regard du four. Le déplacement longitudinal de la nacelle, selon la flèche 10 permet à la zone de solvant 6 de dissoudre le lingot 2 et de cristalliser derrière elle un lingot monocristallin 12 ; l'interface de dissolution porte la référence 13 et l'interface de recristallisation la référence 14.

La dissolution du lingot source 2 par la zone de solvant 6 entraîne une modification de la composition initiale de la zone de solvant. Le processus de croissance du lingot 12 est établi lorsque la zone de solvant 6, qui est liquide, est en équilibre thermodynamique avec le lingot source 2 et le lingot monocristallin 12.

Dans l'article précité, la méthode est appliquée à la croissance de monocristaux de composés semiconducteurs ternaires de type II-VI ; la zone de solvant initiale, c'est-à-dire la zone de solvant existant avant tout transfert de ladite zone le long du lingot semiconducteur, est constituée de tellure pur.

De même, dans l'article de R. TRIBOULET de février 1977, paru dans la Revue de Physique Appliquée, tome 12, pages 123-128, il est décrit la préparation particulière de cristaux contenant du Cd, du Hg et du Te à partir de barres juxtaposées de CdTe et de HgTe comme matériaux source ou d'alimentation d'une zone de solvant initiale en tellure.

Le choix d'une zone initiale de solvant constituée de tellure pur impose obligatoirement la température de la zone finale de solvant à partir de laquelle on pourra obtenir le cristallisation sous forme d'un monocristal du composé d'alimentation de ladite zone, étant donné que la zone de solvant liquide et le composé solide doivent être en équilibre thermodynamique.

Pour permettre de choisir la température à laquelle pourra se former le monocristal, il a été proposé d'utiliser comme zone de solvant initiale une zone de solvant ayant la composition finale de ladite zone, c'est-à-dire lorsque cette dernière est alors en équilibre thermodynamique avec le composé d'alimentation et le composé cristallisé.

Dans le brevet français n° 8 105 387 du 18 mars 1981 (EP-A 0 060 744), il est décrit une telle zone de solvant. Dans ce brevet, qui se rapporte à l'obtention de composés semiconducteurs contenant du Cd, du Hg et du Te, on utilise comme zone de solvant initiale un mélange constitué de CdTe, de HgTe et de Te, riche en tellure, cette zone de solvant étant alimentée par des barres de CdTe et de HgTe. La préparation d'une zone liquide initiale ternaire riche en tellure contenant du Cd, du Hg et du Te, en équilibre thermodynamique avec le composé solide correspondant, implique de préparer ladite zone de solvant à la température d'équilibre thermodynamique soit la plus élevée qu'il soit et exige de se prémunir contre les fuites de mercure liées à la pression de vapeur élevée de ce constituant.

De plus, dans ce cas où le cadmium est introduit sous forme de composé CdTe, la préparation de la zone de solvant nécessite plusieurs heures, compte tenu de la cynétique de dissolution lente de ce composé dans le liquide HgTe+Te.

On voit donc que dans les différents procédés de l'art antérieur, des problèmes importants se posent à l'homme de l'art pour la préparation sous forme de monocristaux de composés ternaires ou quaternaires, notamment de formules $Cd_xHg_{0,5-x}Te_{0,5}$ et $Cd_xHg_{0,5-x}Te_yS_{0,5-y}$, lorsque l'on emploie la méthode de transfert d'une zone de solvant.

En effet, pour obtenir des monocristaux de composés semiconducteurs purs et de bonne qualité cristalline, il est nécessaire de réaliser la zone de solvant initiale à une température aussi modérée que possible, cette zone étant apte à atteindre au mieux l'équilibre thermodynamique avec le solide tenant lieu de composé d'alimentation de ladite zone.

La présente invention a justement pour objet un procédé de préparation d'une zone de solvant initiale permettant de remédier aux inconvénients de l'art antérieur cité, tout en étant d'une mise en œuvre aussi simple que les procédés de cet art antérieur.

De façon plus précise, l'invention a pour objet un procédé de préparation d'une zone de solvant initiale binaire pour la cristallisation sous forme d'un monocristal d'un composé ternaire ou quaternaire polycristallin, de composition déterminée et contenant du cadmium et du mercure, tel que défini dans la revendication 1, et un procédé de préparation d'un monocristal d'un composé ternaire ou quaternaire de composition déterminée, contenant du cadmium et du mercure, par recristallisation d'un polycrystal de ce composé à partir d'une zone de solvant liquide ternaire ou quaternaire en équilibre thermodynamique avec le composé, tel que défini dans la revendication 4.

Ce procédé permet de choisir la température de fonctionnement à laquelle on veut effectuer la cristallisation sous forme de monocristaux d'un composé ternaire ou quaternaire et il permet de préparer la zone initiale de solvant à une température aussi basse que possible.

Ce procédé de préparation s'applique avantageusement à la cristallisation des composés ternaires de formule $Cd_xHg_{0,5-x}Te_{0,5}$ et des composés quaternaires de formule $Cd_xHg_{0,5-x}Te_ySe_{0,5-y}$, formules dans lesquelles x et y sont des nombres compris entre 0 et 0,5.

Dans ce cas particulier, la zone de solvant initiale est de préférence une zone riche en tellure contenant du tellure et du mercure; cette zone de solvant peut être réalisée par fusion et dissolution de Te et de HgTe en quantités appropriées.

D'autres caractéristiques et avantages de l'invention ressortiront de la description qui va suivre, donnée à titre explicatif et non limitatif. La description se réfère aux figures annexées dans lesquelles:

– la figure 1, déjà décrite, illustre le procédé de cristallisation sous forme monocristalline d'un composé par transfert d'une zone de solvant,

– la figure 2 représente le diagramme d'équilibre des phases des composés ternaires de formule $Cd_xHg_{0,5-x}Te_{0,5}$; les valeurs en abscisse concernent la concentration en cadmium desdits composés et les valeurs en ordonnées la concentration en mercure, et

- la figure 3 représente un diagramme donnant la pression de vapeur de mercure $P_{Hg}$, en atmosphère, en fonction de la température T exprimée en $°K^{-1}$, au-dessus des zones liquides binaires ou ternaires.

Dans les procédés d'élaboration de composés ternaires ou quaternaires semiconducteurs sous forme de monocristaux par la méthode de transfert d'une zone de solvant, le processus de croissance des monocristaux est établi lorsque la zone de solvant est en équilibre thermodynamique avec le composé source et le composé monocristallin constitué. La zone de solvant est alors un liquide ternaire ou quaternaire de Cd, Hg et Te ou de Cd, Hg, Te et Se selon que le composé est un composé ternaire ou quaternaire de ces mêmes constituants.

En vue d'une simplification, la description qui suit se réfère à la réalisation de monocristaux de $Cd_xHg_{0,5-x}Te_{0,5}$ avec $0 < x < 0,5$. Bien entendu, le procédé selon l'invention est applicable à toute composition de composés ternaires ou quaternaires de type $Cd_xHg_{0,5-x}Te_{0,5}$ ou $Cd_xHg_{0,5-x}Te_ySe_{0,5-y}$.

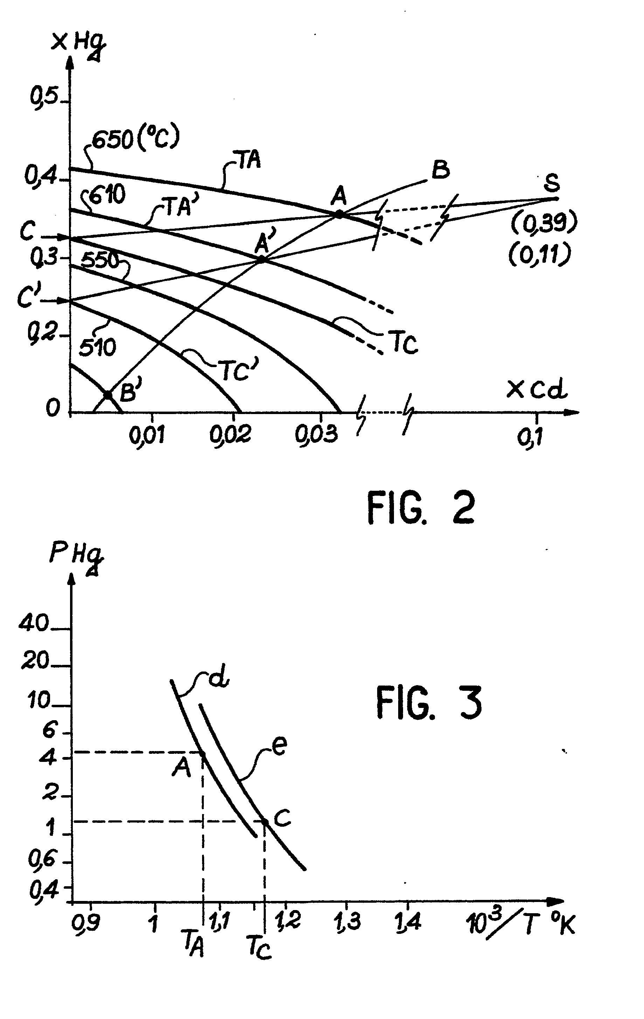

La figure 2 est une représentation du diagramme d'équilibre des phases des composés de formule $Cd_xHg_{0,5-x}Te_{0,5}$ ; les valeurs en abscisse donnent la concentration en cadmium et les valeurs en ordonnées la concentration en mercure de ces composés. L'origine O des axes représente le tellure pur. Sur ce diagramme, on trace les lieux des points où chaque liquide est en équilibre thermodynamique avec son solide à une température donnée, c'est-à-dire les isothermes liquides 650°C, 610°C, ... 510°C.

Le procédé selon l'invention consiste tout d'abord, pour un composé ternaire de composition donnée, que l'on désire cristalliser sous forme monocristalline, à déterminer le point S représentant ce composé, ce point S ayant comme abscisse la concentration en cadmium dudit composé et en ordonnée la concentration en mercure de ce même composé. Le composé considéré présente ici la formule $Cd_{0,11}Hg_{0,39}Te_{0,5}$.

Puis on trace la courbe BB' qui représente, à différentes températures, le lieu des compositions de la zone de solvant en équilibre thermodynamique avec le composé représenté par le point S.

Ensuite, on choisit la température $T_A$ à laquelle on veut effectuer la cristallisation du composé en zone de solvant par exemple à 650°C. Cette courbe de température coupe la courbe BB' en un point A, point qui représente la composition finale de la zone de solvant. Ici cette composition finale correspond à la formule $Cd_{0,03}Hg_{0,35}Te_{0,62}$. A partir de cette composition A, on effectuera la cristallisation du composé $Cd_{0,11}Hg_{0,39}Te_{0,5}$, comme décrit précédemment en référence à la figure 1.

Enfin, on trace la droite passant par le point A et le point S, droite qui constitue le lieu des compositions de la zone liquide dissolvant le composé représenté par le point S lorsque l'on élève la température de ladite zone de la température Te jusqu'à la température $T_A$; cette droite coupe l'axe des ordonnées du diagramme en un point C. Ce point C donne la composition de la zone de solvant initiale binaire ainsi que la température $T_C$ à laquelle doit être préparée cette zone de solvant. Cette température $T_C$ est nettement inférieure à la température de fonctionnement choisie $T_A$.

Dans l'exemple considéré, la zone de solvant initiale, qui est une zone de solvant riche en tellure, présente la composition $Hg_{0,33}Te_{0,67}$ ; cette composition doit être réalisée à une température de 580°C.

Pour le même composé S, par exemple de formule $Cd_{0,11}Hg_{0,39}Te_{0,5}$, on peut choisir une autre température que $T_A$ pour effectuer la cristallisation du composé S, par exemple une température $T_A$, inférieure à $T_A$. La courbe de température $T_A$', ici de 610°C, coupe la courbe BB' en un point A'. Comme précédemment, la construction de la droite A'S, qui constitue le lieu des compositions de la zone liquide dissolvant le composé représenté par le point S lorsque l'on élève la température de cette zone jusqu'à la température $T_A$', permet de déterminer la composition de la zone de solvant initiale binaire ainsi que la température à laquelle celle-ci doit être préparée. Au point C' qui est l'intersection entre la droite A'S et l'axe des ordonnées du diagramme, la composition de la zone de solvant initiale binaire est voisine de $Hg_{0,24}Te_{0,76}$ et la température à laquelle celle-ci doit être préparée est de 510°C. Cette température $T_{C'}$ est inférieure à la température $T_{A'}$ de fonctionnement choisie du système thermodynamique. Le procédé laisse donc le choix de la température de cristallisation.

Après détermination de la composition de la zone de solvant initiale, celle-ci peut être réalisée, dans le cas des composés ternaires de formule $Cd_xHg_{0,5-x}Te_{0,5}$ par fusion et dissolution de Te et de HgTe par exemple en quantités appropriées. Il en est de même pour les composés quaternaires de formule $Cd_xHg_{0,5-x}Te_ySe_{0,5-y}$. La fusion de la zone de solvant initiale peut être réalisée rapidement à l'aide d'un moyen de chauffage des plus simples.

Etant donné que la température de préparation de la zone de solvant initiale binaire est relativement modérée, par exemple de 580°C, lorsque l'on désire obtenir la cristallisation du composé à la température $T_A$ de 650°C ou de 510°C, lorsque l'on désire réaliser la cristallisation dudit composé à une température $T_{A'}$ de 610°C, permet d'éviter au-dessus du liquide, c'est-à-dire de la zone initiale de solvant, lors de sa préparation, l'établissement d'une pression de vapeur de mercure élevée, ce qui permet de réaliser la zone de solvant initiale sous faible pression de gaz neutre ou réducteur, par exemple à la pression atmosphérique.

Sur la figure 3, on a représenté un diagramme donnant la pression de vapeur de mercure en fonction de la température, au-dessus des zones liquides de solvant.

La courbe d représente la pression de vapeur du mercure en équilibre avec la zone de solvant ayant la composition définie par la courbe BB' de la figure 2, à la température de fusion de ladite zone (température $T_A$ pour le point A, température $T_{A'}$ pour le point A'), et la courbe e la pression de vapeur du mercure en équilibre avec la zone initiale de solvant ayant la composition définie par les ordonnées du diagramme de la figure 2, à la température de fusion de ladite zone (température $T_C$ pour le point C, température $T_{C'}$ pour le point C'), seules les températures et pressions des points A et C ont été représentées sur cette figure.

On constate bien, d'après ces courbes, que la pression de vapeur du mercure est peu élevée lorsque l'on réalise la zone de solvant initiale conformément à l'invention.

En effet, cette pression de vapeur n'est que de $1,4 \times 10^5 Pa$ (1,4 atmosphère) à la température $T_C$ (580°C) pour une zone de solvant initiale ayant la composition C (courbe e) mais elle est de $4 \times 10^5 Pa$ (4 atmosphères) à la température $T_A$ (650°C) pour une zone de solvant initiale ayant le composition A (courbe d) comme cela est utilisé dans les procédés de l'art antérieur.

Dans un exemple de réalisation de l'invention, on a procédé à la cristallisation sous forme de monocristal d'un composé de formule $Cd_{0,11}Hg_{0,39}Te_{0,5}$ obtenu de façon connue telle que celle décrite dans les documents de l'art antérieur au moyen d'une zone de solvant initiale de composition $Hg_{0,33}Te_{0,67}$, composition représentée par le point C de la figure 2. Cette zone de solvant initiale a été préparée par fusion et dissolution de, respectivement 10 g de tellure pur et 25 g de HgTe, à la température de 580°C, température déterminée à partir du diagramme de la figure 2, sous une pression de une atmosphère d'hydrogène ($1,013.10^5$ Pascals). La pression de mercure en équilibre avec cette zone de solvant initiale est voisine de $10^5 Pa$ (une atmosphère) comme cela est représenté par le point C de la figure 3. La température de cette zone initiale de solvant est ensuite élevée jusqu'à 650°C, phase pendant laquelle elle dissout le solide source en partie, zone 15 de la figure 1, pour atteindre la composition d'équilibre thermodynamique, point A de la figure 2. Elle est alors apte à cristalliser un monocristal (12, figure 1) du composé cité, bien adapté à la réalisation de photodétecteurs infrarouges.

## Revendications

1. Procédé de préparation d'une zone de solvant initiale binaire pour la cristallisation, sous forme d'un monocristal d'un composé ternaire ou quaternaire polycristallin de composition déterminée et contenant du cadmium et du mercure, caractérisé en ce qu'il comprend les étapes suivantes:
   - déterminer sur le diagramme d'équilibre des phases du composé, comportant deux axes donnant respectivement la concentration en cadmium et en mercure et les isothermes ($T_A$, $T_{A'}$, $T_C$, $T_{C'}$) où chaque liquide est en équilibre thermodynamique avec son solide à une température donnée, le point S représentant la composition dudit composé,
   - tracer sur ce diagramme de phases, la courbe (BB') représentant les compositions de la zone de solvant en équilibre thermodynamique avec le composé,
   - choisir sur ce diagramme, la température ($T_A$, $T_{A'}$) à laquelle doit s'effectuer ladite cristallisation, la zone de solvant initiale portée à cette température ($T_A$, $T_{A'}$) étant apte à dissoudre le composé polycristallin ternaire ou quaternaire jusqu'à l'obtention d'une zone de solvant liquide respectivement ternaire ou quaternaire, en équilibre thermodynamique avec ledit composé, à partir de laquelle est réalisée ladite cristallisation,
   - établir la droite passant par le point S et le point d'interception (A) de ladite courbe (BB') avec l'isotherme associée à la température de cristallisation choisie, l'interception de cette droite avec l'un desdits axes fixant la composition (C, C') de la zone de solvant binaire initiale ainsi que la tem-pérature ($T_C$, $T_{C'}$) à laquelle doit être préparée cette zone de solvant binaire initiale.

2. Procédé de préparation selon la revendication 1 d'une zone de solvant initiale binaire pour la cristallisation d'un composé ternaire de formule $Cd_x$-

Hg$_{0,5-x}$Te$_{0,5}$ ou d'un composé quaternaire de formule Cd$_x$Hg$_{0,5-x}$Te$_y$Se$_{0,5-y}$, formules dans lesquelles x et y sont des nombres compris entre 0 et 0,5, caractérisé en ce que la zone de solvant initiale binaire est une zone riche en tellure contenant du tellure et du mercure.

3. Procédé selon la revendication 2, caractérisé en ce que l'on réalise la zone de solvant initiale par fusion et dissolution de Te et de HgTe en quantité appropriée.

4. Procédé de préparation d'un monocristal d'un composé ternaire ou quaternaire de composition déterminée, contenant du cadmium et du mercure, par recristallisation d'un polycristal de ce composé à partir d'une zone de solvant liquide ternaire ou quaternaire en équilibre thermodynamique avec le composé, comprenant les étapes suivantes:
– fabriquer un polycristal dudit composé,
– déterminer sur le diagramme d'équilibre des phases du composé, comportant deux axes donnant respectivement la concentration en cadmium et en mercure et les isothermes (T$_A$, T$_{A'}$, T$_C$, T$_{C'}$) où chaque liquide est en équilibre thermodynamique avec son solide à une température donnée, le point S représentant la composition dudit composé,
– tracer sur le diagramme de phases, la courbe (BB') représentant les compositions de la zone de solvant en équilibre thermodynamique avec le composé,
– choisir sur ce diagramme la température (T$_A$, T$_{A'}$) à laquelle doit s'effectuer la recristallisation,
– établir la droite passant par le point S et le point d'interception (A) de ladite courbe (BB') avec l'isotherme associée à la température de recristallisation choisie, l'interception de cette droite avec l'un desdits axes fixant la composition (C, C') de la zone de solvant initiale binaire ainsi que la température (T$_C$, T$_{C'}$) à laquelle doit être préparée cette zone de solvant initiale,
– préparer cette zone de solvant initiale,
– chauffer cette zone de solvant initiale à la température de recristallisation (T$_A$, T$_{A'}$) choisie,
– dissoudre le polycristal dans cette zone de solvant chauffée jusqu'à l'obtention de ladite zone de solvant ternaire ou quaternaire,
– déplacer cette zone de solvant ternaire ou quaternaire chauffée à la température de recristallisation le long du polycristal de façon à transformer ce polycristal en monocristal.

5. Procédé de préparation selon la revendication 4 d'un composé ternaire de formule Cd$_x$Hg$_{0,5-x}$Te$_{0,5}$ ou d'un composé quaternaire de formule Cd$_x$Hg$_{0,5-x}$Te$_y$Se$_{0,5-y}$, formules dans lesquelles x et y sont des nombres compris entre 0 et 0,5, caractérisé en ce que la zone de solvant initiale binaire est une zone riche en tellure contenant du tellure et du mercure.

6. Procédé selon la revendication 5, caractérisé en ce que l'on réalise la zone de solvant initiale par fusion et dissolution de Te et de HgTe en quantité appropriée.

**Claims**

1. Process for the preparation of a binary initial solvent zone permitting crystallization in the form of a monocrystal of a polycrystalline ternary or quaternary compound having a given composition and containing cadmium and mercury, characterized in that it comprises the following stages:
– determining on the phase equilibrium diagram of the component having two axes respectively giving the cadmium and mercury concentration and the isotherms (T$_A$, T$_{A'}$, T$_C$, T$_{C'}$), in which each liquid is in thermodynamic equilibrium with its solid at a given temperature, the point (S) representing the composition of said compound,
– plotting on said phase diagram, the curve (BB') representing the compositions of the solvent zone in thermodynamic equilibrium with the compound,
– choosing on said diagram, the temperature (T$_A$, T$_{A'}$) at which said crystallization has to take place, the initial solvent zone raised to said temperature (T$_A$, T$_{A'}$) being able to dissolve the ternary or quaternary polycrystalline compound until a respectively ternary or quaternary liquid solvent zone is obtained in thermodynamic equilibrium with said compound and from which said crystallization is carried out and
– establishing the straight line passing through point (S) and the interception point (A) of said curve (BB') with the isotherm associated with the chosen crystallization temperature, the interception of said line with one of said axes fixing the composition (C, C') of the initial binary solvent zone and the temperature (T$_C$, T$_{C'}$) at which said initial binary solvent zone has to be prepared.

2. Preparation process according to claim 1 of a binary initial solvent zone for the crystallization of a ternary compound of formula Cd$_x$Hg$_{0,5-x}$Te$_{0,5}$ or a quaternary compound of formula Cd$_x$Hg$_{0,5-x}$Te$_y$Se$_{0,5-y}$, in which x and y are numbers between 0 and 0.5, characterized in that the initial binary solvent zone is a tellurium-rich zone containing tellurium and mercury.

3. Process according to claim 2, characterized in that the initial solvent zone is produced by melting and dissolving Te and HgTe in an appropriate quantity.

4. Process for the preparation of a monocrystal of a ternary or quaternary compound of given composition containing cadmium and mercury by recrystallizing a polycrystal of said compound from a ternary or quaternary liquid solvent zone in thermodynamic equilibrium with the compound and comprising the following stages:
– producing a polycrystal of said compound,
– determining on the phase equilibrium diagram of the component having two axes respectively giving the cadmium and mercury concentration and the isotherms (T$_A$, T$_{A'}$, T$_C$, T$_{C'}$) where each liquid is in thermodynamic equilibrium with its solid at a given temperature, the point (S) representing the composition of said compound,
– plotting on the phase diagram, the curve (BB')

representing the compositions of the solvent zone in thermodynamic equilibrium with the compound,
– choosing on said diagram the temperature ($T_A$, $T_A'$) at which said
– plotting on the phase diagram, the curve (BB') representing the compositions of the solvent zone in thermodynamic equilibrium with the compound,
– choosing on said diagram the temperature ($T_A$, $T_A'$) at which said recrystallization is to take place,
– establishing the straight line passing through the point (S) and the interception point (A) of said curve (BB') with the isotherm associated with the chosen recrystallization temperature, the interception of said line with one of said axes fixing the composition (C, C') of the initial binary solvent zone, as well as the temperature ($T_C$, $T_C'$) at which said initial solvent zone must be prepared,
– preparing said initial solvent zone,
– heating said initial solvent zone to the chosen recrystallization temperature ($T_A$, $T_A'$),
– dissolving the polycrystal in said heated solvent zone until the ternary or quaternary solvent zone is obtained and
– displacing said quaternary or ternary solvent zone heated to the recrystallization temperature along the polycrystal, so as to transform said polycrystal into a monocrystal.

5. Preparation process according to claim 4 of a ternary compound of formula $Cd_xHg_{0.5-x}Te_{0.5}$ or a quaternary compound of formula $Cd_xHg_{0.5-x}Te_ySe_{0.5-y}$, in which x and y are numbers between 0 and 0.5, characterized in that the initial binary solvent zone is a tellurium-rich zone containing tellurium and mercury.

6. Process according to claim 5, characterized in that the initial solvent zone is produced by melting and dissolving Te and HgTe in an appropriate quantity.

**Patentansprüche**

1. Verfahren zur Herstellung einer binären Ausgangslösungsmittelzone zur Kristallisation einer polykristallinen ternären oder quaternären Verbindung mit einer vorgegebenen Zusammensetzung, die Cadmium und Quecksilber enthält, in Form eines Einkristalls, dadurch gekennzeichnet, daß es die folgenden Stufen umfaßt:
- Bestimmung des Punktes S, der die Zusammensetzung der Verbindung angibt, in dem Phasengleichgewichtsdiagramm der Verbindung, das aufweist zwei Achsen, die jeweils die Konzentration an Cadmium und an Quecksilber angeben, sowie die Isothermen ($T_A$, $T_A'$, $T_C$, $T_C'$), bei der jede Flüssigkeit bei einer gegebenen Temperatur im thermodynamischen Gleichgewicht mit ihrem Feststoff steht,
- Einzeichnen der Kurve (BB'), welche die Zusammensetzungen der Lösungsmittelzone im thermodynamischen Gleichgewicht mit der Verbindung darstellt, in dieses Phasendiagramm,

- Auswählen der Temperatur ($T_A$, $T_A'$) in diesem Diagramm, bei der die Kristallisation stattfinden soll, bei der die auf diese Temperatur ($T_A$, $T_A'$) gebrachte Ausgangslösungsmittelzone in der Lage ist, die ternäre oder quaternäre polykristalline Verbindung aufzulösen bis zur Erzielung einer jeweils ternären oder quaternären flüssigen Lösungsmittelzone, die im thermodynamischen Gleichgewicht mit der Verbindung steht, von der ausgehend die Kristallisation durchgeführt wird,
- Einzeichnen der Geraden, die durch den Punkt S und den Schnittpunkt (A) zwischen der Kurve (BB') und der der gewählten Kristallisationstemperatur zugeordneten Isotherme hindurchgeht, und Schneiden dieser Geraden mit einer der genannten Achsen, welche die Zusammensetzung (C, C') der binären Anfangslösungsmittelzone festlegen, sowie der Temperatur ($T_C$, $T_C'$), bei der diese binäre Anfangslösungsmittelzone hergestellt werden soll.

2. Verfahren nach Anspruch 1 zur Herstellung einer binären Anfangslösungsmittelzone für die Kristallisation einer ternären Verbindung der Formel $Cd_xHg_{0.5-x}Te_{0.5}$ oder einer quaternären Verbindung der Formel $Cd_xHg_{0.5-x}Te_ySe_{0.5-y}$, worin x und y Zahlen zwischen 0 und 0,5 bedeuten, dadurch gekennzeichnet, daß die binäre Anfangslösungsmittelzone eine an Tellur reiche Zone ist, die Tellur und Quecksilber enthält.

3. Verfahren nach Anspruch 2, dadurch gekennzeichnet, daß die Anfangslösungsmittelzone hergestellt wird durch Schmelzen und Auflösen von Te und von HgTe in einer geeigneten Menge.

4. Verfahren zur Herstellung eines Einkristalls einer ternären oder quaternären Verbindung mit vorgegebener Zusammensetzung, die Cadmium und Quecksilber enthält, durch Umkristallisation eines Polykristalls dieser Verbindung in einer ternären oder quaternären flüssigen Lösungsmittelzone, die im thermodynamischen Gleichgewicht mit der Verbindung steht, das die folgenden Stufen umfaßt:
- Herstellung eines Polykristalls der genannten Verbindung,
- Bestimmung des Punktes S, der die Zusammensetzung der genannten Verbindung angibt, in dem Phasengleichgewichtsdiagramm der Verbindung, das umfaßt zwei Achsen, die jeweils die Konzentration an Cadmium und an Quecksilber angeben, sowie die Isothermen ($T_A$, $T_A'$, $T_C$, $T_C'$), bei der jede Flüssigkeit bei einer gegebenen Temperatur im thermodynamischen Gleichgewicht mit ihrem Feststoff steht,
- Einzeichnen der Kurve (BB'), welche die Zusammensetzungen der Lösungsmittelzone im thermodynamischen Gleichgewicht mit der Verbindung darstellen, in das Phasendiagramm,
- Auswählen der Temperatur ($T_A$, $T_A'$), bei der die Umkristallisation durchgeführt werden soll, in diesem Diagramm,
- Einzeichnen der Geraden, die durch den Punkt S und den Schnittpunkt (A) zwischen der Kurve (BB') und der der gewählten Umkristallisationstemperatur zugeordneten Isotherme hindurchgeht, und Schneiden dieser Geraden mit einer der Achsen, welche die Zusammensetzung (C, C') der binären Anfangslösungsmittelzone festlegen, sowie der Temperatur ($T_C$, $T_{C'}$), bei der diese Anfangslösungsmittelzone hergestellt werden soll,
- Herstellung dieser Anfangslösungsmittelzone,
- Erwärmung dieser Anfangslösungsmittelzone auf die gewählte Umkristallisationstemperatur ($T_A$, $T_{A'}$),
- Auflösen des Polykristalls in dieser erwärmten Lösungsmittelzone bis zur Erzielung der ternären oder quaternären Lösungsmittelzone und
- Verschieben dieser auf die Umkristallisationstemperatur erwärmten ternären oder quaternären Lösungsmittelzone entlang des Polykristalls zur Umwandlung dieses Polykristalls in einen Einkristall.

5. Verfahren nach Anspruch 4 zur Herstellung einer ternären Verbindung der Formel $Cd_xHg_{0,5-x}Te_{0,5}$ oder einer quaternären Verbindung der Formel $Cd_xHg_{0,5-x}Te_ySe_{0,5-y}$, worin x und y Zahlen zwischen 0 und 0,5 bedeuten, dadurch gekennzeichnet, daß die binäre Anfangslösungsmittelzone eine an Tellur reiche Zone ist, die Tellur und Quecksilber enthält.

6. Verfahren nach Anspruch 5, dadurch gekennzeichnet, daß die Anfangslösungsmittelzone durch Schmelzen und Auflösen von Te und von HgTe in einer geeigneten Menge hergestellt wird.

FIG. 1

FIG. 2

FIG. 3